# EUROPÄISCHE PATENTSCHRIFT

(11) **EP 3 249 415 B1**
(45) Veröffentlichungstag und Bekanntmachung des Hinweises auf die Patenterteilung: **01.12.2021**
(21) Anmeldenummer: 17169368.2
(22) Anmeldetag: 04.05.2017
(51) Int. Cl.: G01R 31/58, G01R 35/00, G01R 31/69

(54) **TESTPUNKTKARTEN-EINRICHTUNG FÜR EINEN PRÜFTISCH MIT FEHLERSUCHE**
TEST POINT CARD DEVICE FOR A TEST BENCH WITH FAULT FINDING
DISPOSITIF DE CARTE DE POINTS DE MESURE POUR UN BANC D'ESSAI INCLUANT LA LOCALISATION DE DÉFAUTS

(30) Priorität: 26.05.2016 DE 102016109741
(43) Veröffentlichungstag der Anmeldung: 29.11.2017
(73) Patentinhaber: TSK Prüfsysteme GmbH, 32457 Porta Westfalica (DE)
(72) Erfinder: RÖBKE, Holger, 32469 Petershagen (DE)
(74) Vertreter: Bremer, Ulrich

(56) Entgegenhaltungen:
- EP-A2- 0 860 703
- WO-A1-01/79871
- DE-A1- 4 436 354
- DE-A1- 19 500 113
- DE-U1- 8 713 233
- DE-U1- 29 920 214

## Beschreibung

Die Erfindung betrifft eine Testpunktkarten-Einrichtung für einen Prüftisch zum Testen von Kabelbäumen oder Kabelsträngen, sowie einen derartigen Prüftisch und ein Verfahren zum Erkennen oder Lokalisieren einer Potentialstörung, z. B. eines Kurzschlusses.

Kabelbäume oder Kabelstränge von Fahrzeugen werden im Allgemeinen vor Einbau im Fahrzeug auf einem Prüftisch auf Durchgängigkeit, ordnungsgemäße Kontaktierung und gegebenenfalls ordnungsgemäße mechanische Verrastung geprüft.

An dem Prüftisch können z. B. bis zu 16.384 Testpunkte vorgesehen sein, die jeweils mit einem Kontakt eines Steckers verbunden werden können. Hierzu sind in dem Prüftisch zum Beispiel 64 Testpunktkarten vorgesehen, die jeweils 128 Testpunkte umfassen, z. B. in einem Modul (Adapter) mit einem oder mehreren Kontakten.

Die Ansteuerung der mehreren Testpunktkarten erfolgt durch eine zentrale Steuereinrichtung des Prüftisches, zum Beispiel einen PC (Personal Computer), wobei eine Datenbusverbindung zwischen der zentralen Steuereinrichtung und den einzelnen Testpunktkarten vorgesehen ist. An dem PC ist im Allgemeinen eine Testeinrichtung mit geeigneter Messtechnik vorgesehen; die Steuereinrichtung (PC) und die Testeinrichtung bilden somit eine zentrale Steuer- und Auswerteeinrichtung. Die Zuführung der Spannungsund Stromwerte zu den einzelnen Testpunkten erfolgt über ein Spannungsversorgungs-Modul, das die einzelnen Testpunktkarten versorgt.

Fehler bzw. Potentialstörungen können bereits in einzelnen Testpunktkarten vorliegen, insbesondere bei der Kontaktierung der Testpunkte in den Adaptern bzw. Aufnahme der Leitung in den Adaptern zur Ausbildung der Testpunkte. Oftmals sind derartige Fehler nicht direkt zu lokalisieren, so dass nicht direkt erkannt werden kann, welche der Testpunkte bzw. welche Testpunktkarte die Potentialstörung hervorgerufen hat. Weiterhin treten Potentialstörungen, z. B. Kurzschlüsse, nach Einstecken der Stecker in die Adapter und Vermessen der Kabelstränge auf Durchlässigkeit und gegenseitige Isolation auf.

Somit wird ein Benutzer im Allgemeinen bei Vorliegen derartiger, nicht direkt zu erkennender Fehler zunächst händisch die Stromversorgungs-Kabel sukzessive aus den Strom- und Versorgungsanschlüssen der einzelnen Testpunkte abziehen, und hierbei überprüfen, ob die Potentialstörung weiterhin vorliegt.

Derartige Suchverfahren sind jedoch bei einer Vielzahl von Testpunktkarten aufwendig. Auch zeigt sich, dass das Einstecken und Entnehmen der Stecker selbst wiederum zu einer Belastung der Steckkontakte führen kann.

Die DE 195 00 113 A1 beschreibt einen Kabeltestadapter zum Testen von Kabelbäumen, der zum Anbringen in einer in eine Matrix eingeteilten Tischfläche eines Kabellegetisches ausgebildet ist. Hierbei ist der Adapter mit einem Halbleiterspeicher ausgerüstet, in welchen Daten über den jeweiligen Adapter abgelegt sind. Hierdurch wird eine Verdrahtung und Zuordnung der einzelnen Adapter vermieden, wobei die Ermittlung der Anbringungsorte in der Matrix des Kabellegetisches und des jeweiligen Adaptertyps programmgesteuert erfolgt. Gemäß einer Weiterbildung weist der Adapter eine elektronische Sperreinrichtung auf, die eine oder mehrere elektrische Anschlussleitungen des Adapters sperrt, wenn der Adapter verschlissen ist, was bei Überschreitung einer vorgegebenen, maximalen Anzahl an Steckzyklen angenommen wird.

Die DE 87 13 233 U1 beschreibt eine Vorrichtung zum Zusammenstellen und Prüfen von Kabelbäumen aus Einzelkabeln oder Teilsträngen, deren Ende jeweils mit einem Stecker verbunden sind. Hierbei weist die Vorrichtung einen Träger für eine Mehrzahl von Prüfköpfen auf, die jeweils eine Steckeraufnahme mit mindestens einem zum Kontakt mit einem Steckerkontaktelement bestimmten Kontaktstift und einer Haltevorrichtung zum zeitweiligen Festhalten eines Steckers in der Steckeraufnahme aufweisen.

Die DE 44 36 354 A1 beschreibt eine Vorrichtung zum gleichzeitigen Prüfen einer Mehrzahl von elektrischen oder elektronischen Teilen, insbesondere zum Prüfen von Kabelbäumen unter Verwendung von Adaptermodulen. Hierbei ist dem Prüflingen jeweils eine Prüflingsaufnahme zugeordnet, die prüflingsspezifisch ausgebildet ist, insbesondere bei Anordnung in Form eines Prüffeldes.

Die DE 299 20 514 U1 beschreibt eine Einrichtung zum Testen mit Steckern versehenen Kabeln mit einer Vielzahl von Adaptern, die jeweils mit einer auf einem bestimmten Stecker zugeordneten Steckeraufnahme vorgesehen sind, eine Messtechnik, einem Rechner zur Auswertung der mit der Messtechnik ermittelten Daten und einem Speicher zur Aufnahme stecker- bzw. adapterspezifischer Daten, und einem PC.

Die WO 01/79871 A1 beschreibt ein Verfahren und eine Einrichtung zum Prüfen von Kabelbäumen unter Verwendung eines programmierbaren Steuerrechners, eines Prüftischs und mit Steckerverbindern des Kabelbaumes verbindbaren Testmodulen, die mit entsprechenden, ein Kontaktierfeld aufweisenden Aufnahmekonturen ausgerüstet sind. Hierbei werden die elektrischen und pneumatischen Funktionen, die zum Betreiben eines Testmoduls notwendig sind, für jedes Testmodul jeweils durch eine dezentrale, intelligente Modulsteuereinheit realisiert, die mit dem jeweiligen Testmodul und dem Steuerrechner sowie einer Pneumatikzuleitung verbunden ist.

Die EP 0 860 703 A2 beschreibt eine Überprüfungseinrichtung, die ein Glied zum Aufnehmen eines Steckers und ein Testfeld aufweist, wobei diese verstellbar sind zwischen einem Verbindungs-Zustand, in dem das Testfeld in einem Eingriff ist und einem getrennten Zustand, in dem Testfeld getrennt bzw. außer Eingriff zu einem Steckergehäuse ist. Hierbei ist ein Antriebsmechanismus zum Verstellen vorgesehen, der durch einen Steuermechanismus gesteuert wird.

Der Erfindung liegt die Aufgabe zugrunde, eine Testpunktkarten-Einrichtung, einen Prüftisch mit mehreren derartigen Testpunktkarten-Einrichtungen sowie ein Verfahren zum Erkennen eines Fehler und/oder einer Potentialstörung zu schaffen, die mit relativ geringem Aufwand eine sichere Erkennung von Fehlern und/oder Potentialstörungen ermöglichen.

Diese Aufgabe wird durch eine Testpunktkarten-Einrichtung nach Anspruch 1, einen Prüftisch mit einer derartigen Testpunktkarten-Einrichtung, sowie ein Verfahren zum Ermitteln eines Fehlers und/oder einer Potentialstörung nach den unabhängigen Ansprüchen gelöst. Die Unteransprüche beschreiben bevorzugte Weiterbildungen.

Das erfindungsgemäße Verfahren ist unter Einsatz der erfindungsgemäßen Testpunktkarten-Einrichtungen, und unter Verwendung eines erfindungsgemäßen Prüftisches ausführbar. Der erfindungsgemäße Prüftisch ist insbesondere zur Ausführung eines erfindungsgemäßen Verfahrens vorgesehen.

Erfindungsgemäß ist vor die einzelnen Testpunktkarten jeweils eine Stromversorgungs-Unterbrechungseinrichtung zur Unterbrechung der Stromversorgung der Module geschaltet, die über einen Testpunkt der Testpunktkarte, den Steuer-Testpunkt, von der Testpunktkarte selbst angesteuert werden kann.

Die Stromversorgungs-Unterbrechungseinrichtung ist insbesondere zur vollständigen galvanischen Trennung nicht nur der mindestens einen Spannungsleitung, sondern auch der Masseleitung vorgesehen. Die Stromversorgungs-Unterbrechungseinrichtung wird vorzugsweise als Relaiseinrichtung, zum Beispiel Relaisplatine ausgebildet, die bei Ansteuerung über den Steuer-Testpunkt der Testpunktkarte die Strom- und Spannungsversorgung der Module galvanisch unterbricht.

Erfindungsgemäß wird somit eine selbsttätige Unterbrechung der Stromversorgung durch die Testpunktkarte selbst ermöglicht, ohne dass hierfür ein zusätzlicher Steuerausgang der Testpunktkarte vorgesehen ist. Somit kann eine Prüfroutine bzw. ein Diagnoseverfahren von der zentralen Steuereinrichtung des Prüftisches gestartet werden, indem die zentrale Steuereinrichtung über den Datenbus sukzessive Stilllegungs- Anforderungssignale an jeweils einen Teil der Testpunktkarten ausgibt, sodass die angesprochenen Testpunktkarten jeweils selbsttätig die Strom- und Spannungsversorgung ihrer Module unterbrechen. Hierbei wird die Strom- und Spannungs-Versorgung der Testpunkte jedoch vorzugsweise nicht unterbrochen, sondern nur die Versorgung der Module.

Somit kann in sukzessiven Prüfschritten jeweils überprüft werden, ob die Potentialstörung weiterhin vorliegt, und daher in mehreren sukzessiven Prüfschritten die Potentialstörung einer Testpunktkarte zugeordnet werden; der Fehler kann insbesondere ein Fehler eines angeschlossenen Moduls dieser Testpunktkarte sein.

Somit ist ein händisches Abstecken der Stromversorgungskabel von den Testpunktkarten nicht mehr erforderlich. Die Prüfroutine kann selbsttätig gestartet werden. Falls somit die zentrale Steuereinrichtung des Prüftisches einen Potentialfehler erkennt, kann sie zunächst ein Anzeigensignal an den Benutzer ausgeben, dass eine Potentialstörung vorliegt und bei einer Bestätigung bzw. Eingabe durch den Benutzer selbsttätig die Prüfroutine starten und den Potentialfehler lokalisieren bzw. zuordnen.

Somit ist auch keine zusätzliche Ausbildung eines Datenausgangs oder Steuerausgangs an einer Testpunktkarte für die eigene Stromunterbrechung und somit keine Hardwareänderung bestehender Testpunktkarten erforderlich.

Die Stromversorgungs-Unterbrechungseinrichtungen können zum Beispiel als Relaisplatinen relativ klein bauend ausgebildet werden, sodass auch die Anbringung in oder unter dem Prüftisch im Allgemeinen nicht problematisch wird.

Die Erfindung kann somit auch nachträglich in bestehende Testpunktkarten und Prüftische eingebaut werden, indem die Stromversorgungs- Unterbrechungseinrichtung vor die Strom- und Versorgungsanschlüsse der einzelnen Testpunktkarten geschaltet und eine an der Stromversorgungs- Unterbrechungseinrichtung vorgesehene Steuerleitung an einen noch freien Testpunkt der Testpunktkarte angeschlossen wird.

Hierbei wird erfindungsgemäß insbesondere auch erkannt, dass die standardisierte Testpunktkarte eine Vielzahl von Testpunkten aufweisen, die im Allgemeinen nicht vollständig durch die anzubringenden Module bzw. Adapter ausgenutzt werden. Es reicht somit ein einzelner freier Testpunkt, um nachfolgend die Steuerleitung anzuschließen. Hierbei kann jeder Testpunkt der Testpunktkarte als Steuer-Testpunkt ausgebildet werden

Vorteilhafterweise gibt die zentrale Steuer- und Auswerteeinrichtung ein übliches zentrales Steuersignal an die betreffende Testpunktkarte, damit die Testpunktkarte den als Steuer-Testpunkt geschalteten Testpunkt auf ein hierfür vorgesehenes Potential, z. B. Masse, legt. Somit sind keine besonderen zentralen Steuersignale erforderlich, sondern lediglich ein auch zum Testen der Kabelstränge vorgesehenes zentrales Steuersignal. Die Testpunktkarte bzw. die Testpunktkarten-Steuereinrichtung reagiert somit in üblicher Weise auf das zentrale Steuersignal, indem sie den als Steuer-Testpunkt dienenden Testpunkt auf das hierfür vorgesehene Aktivierungs-Potential legt.

Weiterhin wird vorzugsweise in der zentralen Steuereinrichtung eine Prüfroutine installiert. Somit kann die zentrale Steuereinrichtung über den Datenbus das als Stilllegungs- Anforderungssignal dienende Steuersignal an die Steuereinrichtung der betreffenden Testpunktkarte ausgeben, woraufhin die Steuereinrichtung der Testpunktkarte an den zum Steuer-Testpunkt ausgebildeten Testpunkt das Aktivierungs-Spannungssignal ausgibt, das über die angeschlossene Steuerleitung als Unterbrechungssignal an die vorgeschaltete Stromversorgungs-Unterbrechungseinrichtung ausgegeben wird, so dass die Strom- und Spannungsversorgung sämtlicher Adapter der Testpunktkarte unterbrochen wird. Der zusätzliche Aufwand für die Programmierung ist nicht so hoch, da die Testpunktkarten und die zentrale Steuereinrichtung vor Testen eines neuen Kabelbaums ohnehin zu programmieren sind.

Zur Ausbildung der Erfindung ist die Testpunktkarte bzw. ihre Steuereinrichtung nicht umzuprogrammieren; die Steuereinrichtung in der Testpunktkarte gibt lediglich entsprechend dem von der zentralen Steuereinrichtung ausgesandten Steuersignal (Stillegungs-Anforderungssignal) auf den hierfür vorgesehenen Testpunkt, d. h. den Steuer-Testpunkt, den von der zentralen Steuereinrichtung angeforderten Spannungswert, z. B. Masse (Low Side-Steuerung).

Somit können vorteilhafterweise die Spannungsversorgungen aller Adapter einer Testpunktkarte abgeschaltet werden, wobei die Testpunkte und die Steuereinrichtung der Testpunktkarte bestromt bleiben. Somit kann insbesondere auch das Unterbrechungssignal von der Steuereinrichtung der Testpunktkarte über den Testpunkt wieder ausgeschaltet werden.

Die zentrale Steuereinrichtung wird vorteilhafterweise angelernt, um Daten über die jeweiligen Steuer-Testpunkte der einzelnen Testpunktkarten zu erhalten. Dies kann durch eine Programmierung erfolgen; weiterhin kann z. B. in einem Lern-Modus der Steuer-Testpunkte jeder Testpunktkarte auf Masse gesetzt und/oder mit der Stromversorgungs- Unterbrechungseinrichtung kontaktiert werden, so dass die zentrale Steuereinrichtung dies lernt; entsprechend können diese Anlerndaten auch von den Testpunktkarten erfasst und an die zentrale Steuereinrichtung gemeldet werden.

Zur Lokalisierung einer fehlerhaften Testpunktkarte sind unterschiedliche Routinen möglich: so können die Testpunktkarten linear abgeschaltet werden, zum Beispiel zunächst die letzte, nachfolgend dann die vorletzte, usw., wobei jeweils nach Abschalten einer Testpunktkarte überprüft wird, ob der Potentialfehler weiterhin vorliegt.

Bei einer hohen Anzahl von Testpunktkarten können diese auch blockweise abgeschaltet werden, wobei mehrere, z. B. fünf Testpunktkarten als ein Block geschaltet sind. Somit wird jeweils ein Block ausgeschaltet; falls nachfolgend bei der Überprüfung ermittelt wird, dass der Potentialfehler nicht mehr vorliegt, werden dann in dem Block die einzelnen Testpunktkarten wieder eingeschaltet und zum Beispiel linear ausgeschaltet, um zu ermitteln, bei welcher Testpunktkarte der Potentialfehler vorliegt.

Weiterhin kann die Vielzahl von Testpunktkarten auch durch sukzessive Approximation bzw. Unterteilung ermittelt werden, in dem zum Beispiel zwei gleich große oder etwa gleich große Hälften gebildet werden, von denen eine durch Stilllegungs-Anforderungssignale stillgelegt wird,
und für den Fall, dass kein Potentialfehler mehr vorliegt, die stillgelegte Hälfte nachfolgend wiederum in Hälften untersucht wird,
und im anderen Fall, falls der Fehler weiterhin vorliegt, die stillgelegte Hälfte nachfolgend in Hälften unterteilt wird,
bis in wenigen Schritten auch eine hohe Anzahl von Testpunktkarten untersucht und somit der Fehler lokalisiert bzw. zugeordnet werden kann.

Gemäß einer weiteren Ausbildung der Erfindung kann der Benutzer auch selektiv eine Testpunktkarte stilllegen, indem er ein manuelles Auswahlsignals mit der Angabe einer oder mehrerer Testpunktkarten eingibt; in diesem Fall gibt die zentrale Steuereinrichtung nachfolgend ein Stilllegungs-Anforderungssignal an lediglich die ein oder mehreren ausgewählten Testpunktkarte aus. Eine solche Vorgehensweise ermöglicht somit z. B., bei Erkennen einer möglicherweise problematischen Testpunktkarte oder z. B. eines locker wirkenden Steckers diese Testpunktkarte gezielt stillzulegen, um nicht die ganze Routine zu starten.

Die Erfindung wird im Folgenden anhand der beiliegenden Zeichnungen an einer Ausführungsform erläutert. Es zeigen:
- Fig. 1: eine Testpunktkarten-Einrichtung gemäß einer Ausführungsform der Erfindung;
- Fig. 2: einen Prüftisch mit mehreren Testpunktkarten-Einrichtungen in schematisierter Darstellung;
- Fig. 3: ein Flussdiagramm eines Verfahrens gemäß einer Ausführungsform der Erfindung;
- Fig. 4: einen weiteren Prüftisch gemäß einer Ausführungsform mit mehreren Testpunktkarten-Einrichtungen in schematisierter Darstellung.

Ein Prüftisch 1 weist mehrere Testpunktkarten 2 auf, die jeweils eine Testpunkt-Steuereinrichtung 3 aufweisen und mit ihrer Bus-Schnittstelle 13 über ein Bussystem 12, z. B. nach dem Daisy-Chain-Prinzip, an eine gemeinsame, zentrale Steuereinrichtung 4, zum Beispiel einen separaten PC (personal computer) mit einer zusätzlichen Messtechnik 7, angeschlossen sind.

Auf den Testpunktkarten 2 ist jeweils eine Vielzahl von Testpunkten 6 vorgesehen, die jeweils elektrische Kontakte darstellen. Der Prüftisch 1 kann zum Beispiel achttausend bis sechzehntausend Testpunkte 6 aufweisen, die zum Beispiel in vierundsechzig Testpunktkarten 2 mit zum Beispiel jeweils hundertachtundzwanzig Testpunkten 6 unterteilt sind.

Die Testpunkt-Steuereinrichtungen 3, z. B. ein oder mehrere ASICs (application specific integrated circuits), umfassen hierbei z. B. jeweils eine Testpunkt-Treibereinrichtung sowie eine Messtechnik-Einrichtung, auf die hier nicht genauer eingegangen wird.

Auf den Testpunktkarten 2 sind jeweils ein oder mehrere Module (Adapter) 8 angebracht, die jeweils an z. B. acht Testpunkte 6 angeschlossen werden und zur Aufnahme von Steckern 9 eines Kabelbaums 10, z. B. zum Einbau in einem Fahrzeug, dienen. Über die Testpunkt- Steuereinrichtungen 3 der mehreren Testpunktkarten 2 werden hierzu Prüf-Modi oder Prüfverfahren durchgeführt, bei denen zum Beispiel unterschiedliche Testpunktkontakte 2 auf Durchlässigkeit überprüft werden, d.h. ob sie über den Kabelbaum 10 in galvanischem Kontakt sind.

Hierzu werden im Allgemeinen Prüfverfahren von der zentralen Steuereinrichtung 4 durchgeführt, die die Testpunktkarten 2 ansteuert, so dass diese ihre jeweiligen Testpunkte 6 ansteuern bzw. bestromen. Hierbei kann jeder Testpunkt 6 gegen sämtliche anderen verfügbaren Testpunkte 6 des Prüftisches 1 geprüft werden.

Die Strom- und Spannungsversorgung der Testpunkte 6 ist getrennt von der Strom- und Spannungsversorgung der Module 8 und anderen Einrichtungen auf der Testpunktkarte 2. So erfordern die Module 8 zum Teil eine Stromversorgung für ihre Verstell-Mechanismen.

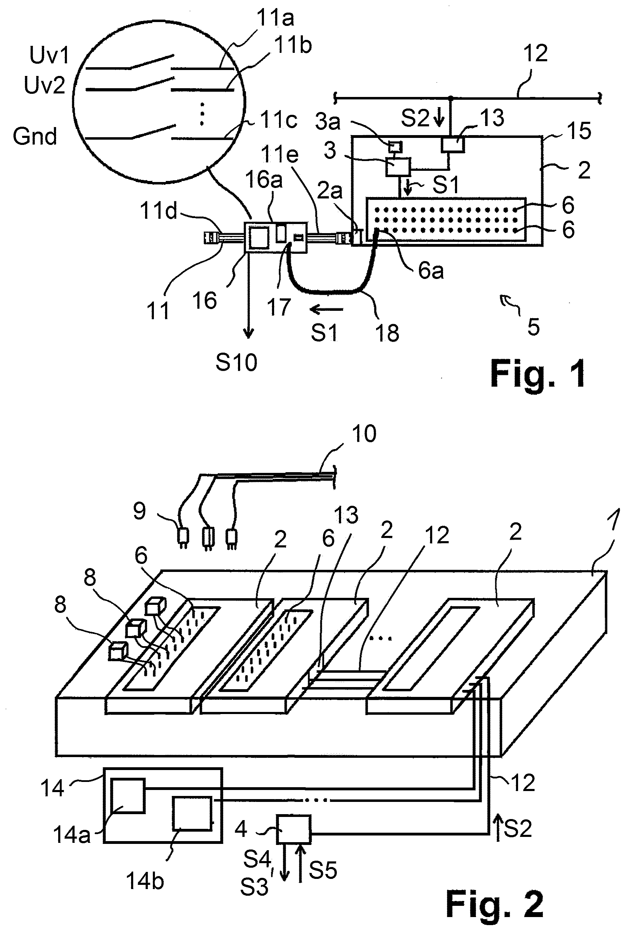

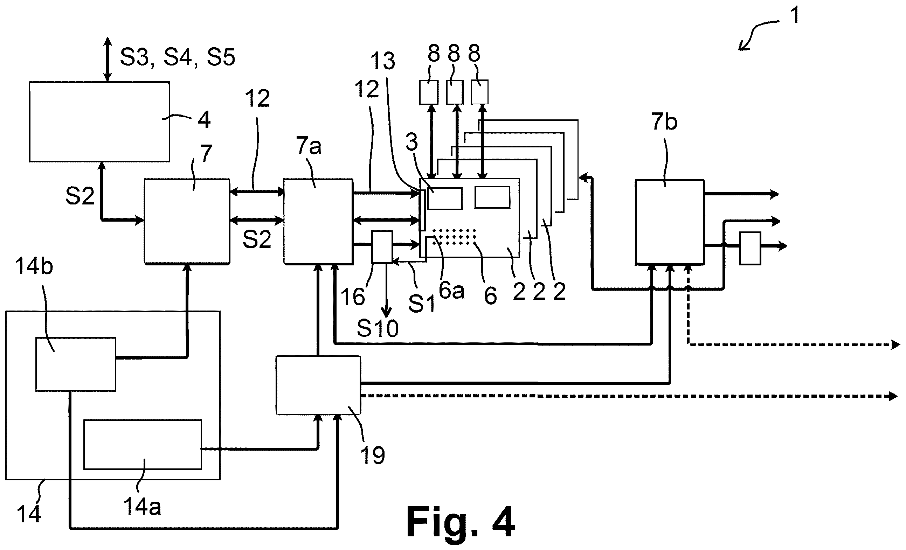

Gemäß Fig. 2 und insbesondere auch der Ausführungsform der Fig. 4 ist eine zentrale Leistungsversorgungseinrichtung 14 (Power Supply Modul) vorgesehen, die eine Adapter-Leistungsversorgungseinheit 14a zur Leistungsversorgung der Adapter (Module) 8, z. B. mit 12V oder 24V, und eine hiervon separate Testpunkt-Leistungsversorgungseinrichtung 14b zur Leistungsversorgung der Testpunkte 6, z. B. mit 5 V, aufweist. Durch diese getrennten Leistungsversorgungseinrichtungen (Power Supplies) 14a und 14b ist eine Potentialentkopplung der Leistungsversorgungen der Adapter (Module) 8 und der Testpunkte 6 sichergestellt.

Gemäß den Ausführungsformen der Fig. 2 und 4 sind hierbei unterschiedliche Leistungs-Zuführungen oder Leistungs-Verteilungen möglich. Gemäß der symbolischen Ausführungsform der Fig. 2 können die Testpunktkarten 2 direkt in einem Bussystem angeordnet sein; eine genauere Ausführungsform nach Fig. 4 zeigt eine Ausbildung, bei der Verteilereinrichtungen, hier ein Input/Output-Master 7a und Input/Output-Slaves 7b, über den Daisy-Chain-Bus 12 mit einer Kabeltester-Einrichtung 7 (Messtechnik) verbunden sind, wobei an diese Verteilereinrichtungen 7a, 7b dann z. B. Blöcke von Testpunktkarten 2, z. B. Blöcke von jeweils fünf Testpunktkarten 2 in enem Daisy-Chain-Bus 12 angeschlossen sind.

Somit wird gemäß der Ausführungsform der Fig. 4 durch die Testpunkt-Leistungsversorgungseinrichtung 14b zunächst die Messtechnik bzw. Kabeltester-Einrichtung 7 versorgt, die mit der zentralen Steuereinrichtung 4 z. B. über einen Ethernet-Bus verbunden ist, wobei die Kabeltester-Einrichtung 7 über einen Daisy-Chain-Bus 12 mit den einzelnen Testpunktkarten 2 verbunden ist..

Die Adapter-Leistungsversorgungseinrichtung 14a und Testpunkt- Leistungsversorgungseinrichtung 14b können gemäß der Ausführungsform der Fig. 4 über eine Spannungs-Verteilereinrichtung (Voltage Distribution Board) 19 angeschlossen sein, die z. B. die Verteilerzentren 7a, 7b mit Leistung, z. B. unterschiedlichen Spannungspegeln von 24 V, 12 V und 5 V, versorgt, die dann wiederum die einzelnen Testpunktkarten 2 mit ihren Testpunkten 6 mit Leistung versorgt.

In der Adapter-Leistungsversorgung zu den einzelnen Testpunktkarten 2 ist für jede Testpunktkarte 2 eine Stromversorgungs-Unterbrechungseinrichtung 16, zum Beispiel als Relaisplatine 16 vorgesehen. Die Relaisplatine 16 ist z. B. gemäß Fig. 1 in das Stromkabel 11 eingesetzt bzw. zwischengeschaltet, so dass es Abschnitte 11d und 11e des Stromkabels 11 trennt. Die Relaisplatine 16 weist einen Steuereingang 17 auf, an den ein Steuerkabel 18 angeschlossen ist, das wiederum an einen der Testpunkte 6 der angeschlossenen Testpunktkarte 2 angeschlossen wird. Der hier ausgewählte, nicht von einem Modul 8 belegte Testpunkt wird als Steuer-Testpunkt 6a bezeichnet; grundsätzlich kann jeder der Testpunkte 6 als Steuer-Testpunkt 6a ausgewählt werden. Die Steuerleitung 18 ist somit vorzugsweise einpolig und wird zum Beispiel als Steckkontakt in bzw. an den Steuer-Testpunkt 6a angeschlossen. Die Steuerleitung 18 kann hierbei bereits fest an die Relaisplatine 16 angeschlossen sein.

Durch die Steuerleitung 18 hat jede Testpunktkarte 2 die Möglichkeit, die Stromversorgung ihrer Module 8 durch Ansteuerung der Relaisplatine 16 mit einem Unterbrechungssignal S1 zu unterbrechen. Die Relaisplatine 16 kann vorteilhafterweise, wie in der Ausschnittsvergrößerung der Fig. 1 angedeutet, nicht nur spannungsführende Leitungen 11a und 11b, sondern auch die Masse-Leitung 11c unterbrechen und somit eine vollständige galvanische Abkopplung der Module 8 der Testpunktkarte 2 von der Adapter- Leistungsversorgungseinrichtung 14a ermöglichen.

Das Unterbrechungssignal S1 ist hierbei ein übliches Spannungssignal, das von der Testpunktkarte 2 über ihre Testpunkte 6 ausgegeben wird. Vorteilhaft ist hierbei eine Low Side-Ansteuerung, d. h. der betreffende Steuer-Testpunkt 6a wird auf Masse gesetzt, d. h. ein 0 V-Signal, das über die Steuerleitung 18 an den Steuereingang 17 der Relaisplatine 16 ausgegeben wird.

Zum Stilllegen der Module 8 einer Testpunktkarte 2 wird von der zentralen Steuereinrichtung 4 ein Steuersignal S2, das als Stilllegungs- Aufforderungssignal S2 bezeichnet wird, ausgegeben. Hierzu gibt die zentrale Steuereinrichtung 4 in üblicher Weise ein Steuersignal an die betreffende Steuereinrichtung 3 der Testpunktkarte 2, dass diese den Steuer-Testpunkt 6a auf Masse legt.

Ergänzend kann vorgesehen sein, dass die Unterbrechungseinrichtung 16 ein Ausgabe-Signal S10 an eine andere Einheit ausgibt, um den Fehler und die Stilllegung anzuzeigen.

Wird somit eine Potentialstörung an dem Prüftisch 1 festgestellt, was zum einen bereits bei der Ausbildung des Prüftisches 1, zum Beispiel einer Erweiterung des Prüftisches 1 erfolgen kann, oder auch beim nachfolgenden Prüfverfahren zum Prüfen eines Kabelbaums 10, so kann ein erfindungsgemäßes Verfahren zum Ermitteln einer Potentialstörung gestartet werden.

Das Verfahren kann grundsätzlich selbsttätig gestartet werden; vorteilhafterweise wird jedoch zunächst von der zentralen Steuereinrichtung 4 ein Fehler-Anzeigesignal S4 (Störungssignal) ausgegeben, woraufhin der Benutzer durch ein Initiierungssignal S5 das Verfahren bzw. die Diagnoseroutine startet.

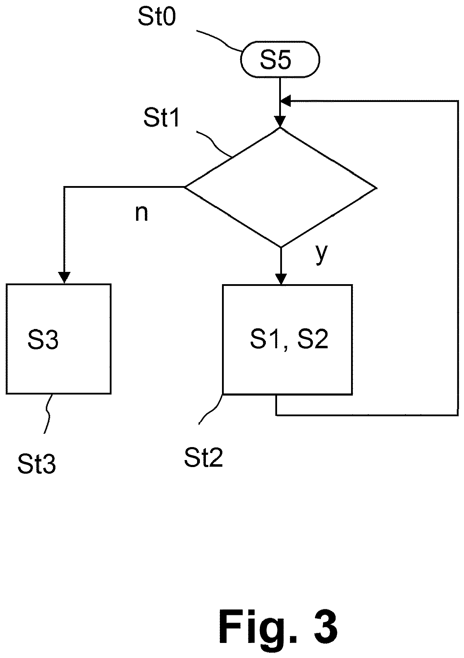

Gemäß diesem Verfahren wird, wie auch in dem Flussdiagramm der Figur 3 schematisch gezeigt, bei dem nach dem Start in Schritt St0
- nachfolgend in Schritt St1 jeweils überprüft wird, ob Fehler wie z. B. Potentialstörungen vorliegen, zum Beispiel eine nicht saubere Trennung der verschiedenen Potentiale,
- bei Nicht-Vorliegen einer entsprechenden Potentialstörung gemäß Verzweigung n nachfolgend in Schritt St3 das Verfahren z. B. durch Ausgabe eines Anzeigesignals S3 beendet wird,
- bei Vorliegen einer entsprechenden Potentialstörung gemäß Verzweigung y dann nachfolgend in Schritt St2 eine Diagnoseroutine (Detektionsroutine) zum Eingrenzen und Lokalisieren des Potentialfehlers gestartet wird, bei der die Potentialstörung einer der mehreren Testpunktkarten 2 zugeordnet wird.

In der Diagnoseroutine des Schrittes St2 werden sukzessive Testpunktkarten 2 durch Ansteuerung ihrer Relaisplatine 16 von der Stromversorgung genommen und somit ausgeschaltet,
woraufhin das Verfahren wieder vor den Schritt St1 zurück gesetzt wird.

Falls somit in Schritt St1 festgestellt wird, dass der Potentialfehler weiterhin vorliegt, werden nachfolgend wiederum ein oder mehrere weitere Testpunktkarten 2 still gelegt, so dass die verbleibenden Testpunktkarten 2 sukzessive überprüft werden.

Am Schluss wird jeweils gemäß Schritt St3 der Fehler lokalisiert und in dem Anzeigesignal S3 angezeigt.

Hierbei können verschiedene Routinen zum sukzessiven Stilllegen der Testpunktkarten 2 gefahren werden:
gemäß einer Variante können die einzelnen Testpunktkarten 2 einzeln sukzessive ausgeschaltet werden, zum Beispiel in der Reihe in der sie an den Datenbus bzw. Daisy-Chain-Bus angeschlossen sind, von hinten nach vorne,
das heißt ein lineares Abschalten,
gemäß einer zweiten Variante durch ein blockweises Abschalten, wobei jeweils mehrere, z. B. fünf Testpunktkarten 2 als ein Block geschaltet sind, sodass einzelne Blöcke abgeschaltet sind,
oder als dritte Variante durch Unterteilen der vorhandenen Anzahl der Testpunktkarten 2. So kann zum Beispiel zunächst die Hälfte der Testpunktkarten 2, bei zum Beispiel vierundsechzig Testpunktkarten somit zweiunddreißig Testpunktkarten abgeschaltet werden, und dann nachfolgend in Schritt St1 überprüft werden, ob der Fehler noch vorliegt, und dann jeweils die die Störung hervorrufende Hälfte (bei bestehendem Fehler somit die nicht abgeschaltete Hälfte, sonst bei Nicht-Auftreten des Fehlers die zuletzt abgeschaltete Hälfte) durch Schließen der Stromversorgung über die Relaisplatinen 16 aktiviert werden und die jeweils andere Hälfte deaktiviert werden, woraufhin dann in der aktivierten, von der Störung betroffenen Hälfte der Testpunktkarten 2 wiederum eine Hälfte ausgewählt und ausgeschaltet wird, usw.

Diese drei Routinen können auch kombiniert werden, sodass nach zunächst blockweisem Abschalten dann in einem Block zum Beispiel die fünf betroffenen Testpunktkarten linear überprüft werden.

Somit kann die Zahl der Testpunktkarten 2 sukzessive jeweils halbiert werden, sodass nach einer überschaubaren Anzahl von Schritten der Fehler bei einer Testpunktkarte lokalisiert werden kann.

Nachfolgend können dann die einzelnen Module 8 auf Potentialfehler überprüft werden.

Somit wird ein Fehlererkennungs-Signal S3 ausgegeben, das die betreffende, von der Störung betroffene Testpunktkarte 2 anzeigt.

Unter einem "Abschalten" einer Testpunktkarte 2 wird hierbei in der oben beschriebenen Weise ein Abschalten der Module 8 der Testpunktkarte 2, ggf. auch weiterer Einrichtungen auf der Testpunktkarte 2, verstanden. Die Steuereinrichtung 3 bleibt im Allgemeinen über den Daisy-Chain-Bus 12 bestromt, d. h. weist hier eine eigene, nicht unterbrochene Stromversorgung auf. Somit werden die Testpunkte 6 und die Steuereinrichtung 3 einer Testpunktkarte 2 auch im Falle einer Unterbrechung weiter mit Strom versorgt.

### Bezugszeichenliste

- 1: Prüftisch
- 2: Testpunktkarte
- 2a: Strom- und Spannungsanschluss
- 3: Testpunkt-Steuereinrichtung
- 4: zentrale Steuereinrichtung
- 5: Testpunktkarten-Einrichtung
- 6: Testpunkt

- 6a: Steuer-Testpunkt
- 7: Messtechnik, z. B. Kabeltester-Einrichtung
- 7a: Verteiler-Einrichtungen
- 8: Adapter
- 9: Stecker
- 10: Kabelbaum
- 11: Stromkabel, zum Beispiel 25-polige Flachbandleitung
- 11a und 11b: Versorgungsspannungs-Leitung
- 11c: Masse-Leitung
- 11d, 11e: Stromkabel-Abschnitte
- 12: Bussystem, z. B. als Daisy-Chain
- 13: Bus-Schnittstelle
- 14: zentrale Leistungsversorgungseinrichtung bzw. Stromversorgungseinrichtung (power supply modul)
- 14a: Adapter-Leistungsversorgungseinrichtung
- 14b: Testpunkt-Leistungsversorgungseinrichtung
- 16: Relaisplatine
- 17: Steuereingang der Relaisplatine 16
- 18: Steuerkabel, Steuerleitung
- 19: Leistungs-Verteilereinrichtung (Voltage Distribution Board)
- S1: Unterbrechungssignal S1
- S2: Stilllegungs-Aufforderungssignal S2
- S3: Anzeigesignal
- S4: Störungssignal
- S5: Initiierungssignal
- S10: Ausgabe-Signal
- St0 - St3: Verfahrensschritte

## Patentansprüche

1. Testpunktkarten-Einrichtung (5) für einen Prüftisch (1) zum Prüfen eines Kabelbaums (10) oder Kabelstrangs,
mit einer Testpunktkarte (2), die aufweist:
- eine Vielzahl von Testpunkten (6),
- Module (8) zur Aufnahme jeweils eines Steckers (9) des Kabelbaums (10) oder Kabelstrangs, wobei in einem Modul (8) jeweils ein oder mehrere Testpunkte (6) aufgenommen oder kontaktiert sind,
- einen Strom- und Spannungsanschluss (2a) zum Anschluss eines Stromkabels (11) mit mindestens einer Versorgungsspannungs -Leitung (11a, 11b) und einer Masse-Leitung (11c) zur Leistungsversorgung der Module (8),
wobei eine Stromversorgungs-Unterbrechungseinrichtung (16) vorgesehen ist, durch die die mindestens eine Versorgungsspannungs-Leitung (11a, 11b) und die Masse-Leitung (11c) von den Modulen (8) trennbar ist,
**dadurch gekennzeichnet, dass**
- die Testpunktkarte (2) eine Testpunktkarten-Steuereinrichtung (3) zur Ansteuerung der einzelnen Testpunkte (6) und Datenkommunikation mit einer zentralen Steuereinrichtung (4) des Prüftisches (1) aufweist,
- die Stromversorgungs-Unterbrechungseinrichtung (16) einen SteuerEingang (17) zur Trennung der Leitungen (11a, 11b, 11c) bei Aufnahme eines Unterbrechungssignals (S1) aufweist,
- zwischen einen als Steuer-Testpunkt (6a) dienenden Testpunkt und den Steuer-Eingang (17) eine Steuerleitung (18) geschaltet ist, wobei jeder Testpunkt (6) als Steuer-Testpunkt (6a) über die Steuerleitung (18) kontaktierbar ist, und
- die Testpunkt-Steuereinrichtung (3) ausgebildet ist, bei Empfang eines externen Stilllegungs-Anforderungssignals (S2) ein Unterbrechungssignal (S1) über den Steuer-Testpunkt (6a) und die Steuerleitung (18) zu dem Steuer-Eingang (17) der Stromversorgungs-Unterbrechungseinrichtung (16) auszugeben.

2. Testpunktkarten-Einrichtung (5) nach Anspruch 1, **dadurch gekennzeichnet, dass** die Stromversorgungs-Unterbrechungseinrichtung (16) vor den Strom- und Spannungsanschluss (2a) geschaltet ist.

3. Testpunktkarten-Einrichtung (5) nach Anspruch 2, **dadurch gekennzeichnet, dass** die Stromversorgungs-Unterbrechungseinrichtung (16) zwischen zwei Stromkabel-Abschnitte (11d, 11e) eines Stromkabels (11) mit der Versorgungsspannungs-Leitung (11a, 11b) und der Masseleitung (11c) geschaltet ist, wobei der zweite Stromkabel-Abschnitt (11e) zwischen der Stromversorgungs- Unterbrechungseinrichtung (16) und dem Strom- und Spannungsanschluss (2a) geschaltet ist.

4. Testpunktkarten-Einrichtung (5) nach Anspruch 2 oder 3, **dadurch gekennzeichnet, dass** die Testpunktkarte (2) einen Schaltungsträger, zum Beispiel eine Platine (15) aufweist, auf dem die Testpunktkarten-Steuereinrichtung (3), ein Datenbus-Anschluss, der Strom- und Versorgungsanschluss (2a) angebracht sind,
wobei die Stromversorgungs-Unterbrechungseinrichtung außerhalb des Schaltungsträger (15) auf einem separaten Schaltungsträger (16) aufgenommen ist.

5. Testpunktkarten-Einrichtung (5) nach einem der vorherigen Ansprüche, **dadurch gekennzeichnet, dass** die Stromversorgungs-Unterbrechungseinrichtung (16) als Relais -Einrichtung, zum Beispiel Relais-Platine zum galvanischen Trennen der Leitungen (11a, 11b, 11c) für eine vollständige Potential-Unterbrechung ausgebildet ist.

6. Testpunktkarten-Einrichtung (5) nach einem der vorherigen Ansprüche, **dadurch gekennzeichnet, dass** die Stromversorgung der Testpunkte (6) durch die Stromversorgungs-Unterbrechungseinrichtung (16) nicht unterbrechbar ist und die Testpunktkarten-Steuereinrichtung (3) auch bei durch die Stromversorgungs-Unterbrechungseinrichtung (16) unterbrochener Spannungsversorgung der Module (8) weiterhin mit Leistung versorgt ist

7. Testpunktkarten-Einrichtung (5) nach einem der vorherigen Ansprüche, **dadurch gekennzeichnet, dass** das Unterbrechungssignal (S1) ein Strom- oder Spannungssignal entsprechend der Beaufschlagung der Module (8) mit Stromwerten oder Spannungswerten, vorzugsweise ein Spannungssignal mit konstanter Spannung, z. B. Masse (0 V), ist.

8. Testpunktkarten-Einrichtung (5) nach einem der vorherigen Ansprüche, **dadurch gekennzeichnet, dass** die Testpunktkarte (2) weiterhin eine Schnittstelle (13), insbesondere eine Bus-Schnittstelle (13) für einen Datenbus (12), zur Kommunikation der Testpunktkarten- Steuereinrichtung (3) mit der zentralen Steuereinrichtung (4) des Prüftisches (1) aufweist,
wobei über die Schnittstelle (13) das Stilllegungs-Aufforderungssignal (S2) der zentralen Steuereinrichtung (4) aufnehmbar ist, das die Testpunktkarten-Steuereinrichtung (3) instruiert, den Steuer-Testpunkt (6a) auf ein Potential zu legen oder zu bestromen, und
die Stromversorgung der Schnittstelle (13) und der Testpunktkarten-Steuereinrichtung (3) nicht durch die Stromversorgungs- Unterbrechungseinrichtung (16) unterbrechbar ist, vorzugsweise mit einer Stromversorgung der Testpunktkarten-Steuereinrichtung (3) über die Schnittstelle (13).

9. Testpunktkarten-Einrichtung (5) nach einem der vorherigen Ansprüche, **dadurch gekennzeichnet, dass** die Module (8) Adapter (8) zur vorzugsweise formschlüssigen Aufnahme jeweils eines Steckers (9) des Kabelbaums (10) sind.

10. Testpunktkarten-Einrichtung (5) nach einem der vorherigen Ansprüche, **dadurch gekennzeichnet, dass** die Stromversorgungs-Unterbrechungseinrichtung (16) weiterhin ein Ausgabe-Signal (S10) an eine weitere Einrichtung ausgibt.

11. Prüftisch (1) zum Prüfen eines Kabelbaums (10) oder Kabelstrangs, wobei der Prüftisch (1) aufweist:
eine zentrale Steuereinrichtung (4), zum Beispiel ein PC,
mehrere Testpunktkarten-Einrichtungen (5) nach einem der vorherigen Ansprüche,
einen Datenbus (12), über den die Testpunktkarten (2) jeweils mit der zentralen Steuereinrichtung (4) verbunden sind,
wobei die Testpunktkarten (2) jeweils bei Anschluss der Steuerleitung (18) an einen ihrer Testpunkte (6) zur selbsttätigen Trennung der Stromversorgung ihrer Module (8) ausbildbar sind,
wobei die zentrale Steuereinrichtung (4) ausgebildet ist zur Ausgabe von Stilllegungs-Anforderungssignalen (S1) an die einzelnen Testpunktkarten (2) über den Datenbus (12),
wobei innerhalb oder außerhalb der zentralen Steuereinrichtung (4) eine Prüfroutine gespeichert ist, bei deren Aktivierung von der zentralen Steuereinrichtung (4) die Stilllegungs-Anforderungssignale (S1) sukzessive ausgebbar sind zur aufeinander folgenden Abschaltung der Testpunktkarten (2) unter Lokalisierung einer Potentialstörung an einer oder mehreren einzelnen Testpunktkarten (2).

12. Prüftisch (1) nach Anspruch 11, **dadurch gekennzeichnet, dass** die Stromkabel (11) zur Leistungsversorgung der Module (8) der einzelnen Testpunktkarten-Einrichtungen (5) an eine zentrale Adapter-Stromversorgungs-Einrichtung (14a) angeschlossen sind, und weiterhin die Testpunkte (6) der Testpunktkarten (2) an eine gemeinsame Testpunkt-Leistungs-Versorgung (14b) angeschlossen sind, z. B. jeweils in Stern-Konfiguration oder als Kette.

13. Prüftisch (1) nach Anspruch 11 oder 12, **dadurch gekennzeichnet, dass** in einem internen oder externen Speicher der zentralen Steuereinrichtung (4) eine Prüfroutine gespeichert ist, zur sukzessiven Abschaltung der mehreren Testpunktkarten-Einrichtungen (5) durch Ausgabe von Stilllegungs-Aufforderungssignalen (S2) bei Erkennen einer Potentialstörung und/oder bei Aufnahme eines Initiierungssignals (S5).

14. Prüftisch (1) nach einem der Ansprüche 11 bis 13, **dadurch gekennzeichnet, dass** in einem internen oder externen Speicher der zentralen Steuereinrichtung (4) gespeichert ist, welcher Testpunkt der einzelnen Testpunktkarten (2) jeweils den Steuer-Testpunkt (6a) bilden, z. B. als Nummer oder Adresse des Steuer-Testpunktes (6a).

15. Verfahren zum Erkennen einer fehlerhaften Testpunktkarte (2) eines Prüftisches (1) nach einem der Ansprüche 11 bis 14, mit mindestens folgenden Schritten:
sukzessives Ausgeben von Stilllegungs-Anforderungssignalen (S1) von der zentralen Steuereinrichtung (4) an die Testpunkt- Steuereinrichtung (3) der einzelnen Testpunktkarten (2),
bei Aufnahme eines Stilllegungs-Anforderungssignals (S1) durch eine Testpunktkarten-Steuereinrichtung (3) Ausgabe eines Spannungssignals als Unterbrechungssignal (S2) über einen Testpunkt (6) und eine Steuerleitung (18) an eine Stromversorgungs- Unterbrechungseinrichtung (16), zur Potentialtrennung und/oder galvanischen Trennung der Leitungen (11a, 11b, 11c) zur Versorgung der Module (8),
Lokalisieren durch sukzessives Abschalten der einzelnen Testpunktkarten (2), bis die mindestens eine Testpunktkarte (2) mit der Potentialstörung oder dem Fehler erkannt ist.

16. Verfahren nach Anspruch 15, **dadurch gekennzeichnet, dass** es mindestens folgende Schritte aufweist:
Überprüfen, ob ein Fehler, insbesondere eine Potentialstörung, z. B. ein Kurzschluss, vorliegt (St1),
Ausgabe von Stilllegungs-Anforderungssignal (S2) an einen Teil der Testpunktkarten (2) (St2),
bei Empfang eines Stilllegungs-Anforderungssignals (S2) durch eine Testpunktkarten-Steuereinrichtung (3) einer Testpunktkarte (2) Ausgabe eines Unterbrechungssignals (S1) an die vorgeschaltete Stromversorgungs-Unterbrechungseinrichtung (16), zur galvanischen Unterbrechung der Spannungsleitungen (11a, 11b) und einer Masseleitung (11c) zu den Modulen (8) der Testpunktkarte (2),
sukzessives Wiederholen der Schritte des Überprüfens auf einen Fehler und/oder Potentialstörung und Ausgabe von Stilllegungs- Anforderungssignalen (S2) zur Ortung oder Identifizierung der fehlerhaften Testpunktkarte (2).

17. Verfahren nach Anspruch 15 oder 16, **dadurch gekennzeichnet, dass** die mehreren Testpunktkarten (2) gemäß einem der folgenden Verfahren sukzessive durch die Stilllegungs-Anforderungssignale (S2) angesteuert werden:
- blockweises Ansteuern von mehreren Testpunktkarten (2) zur Erkennung eines fehlerhaften Blocks mit nachfolgender Erkennung der fehlerhaften Testpunktkarte (2) in dem Block,
- serielle Ansteuerung durch Ausgabe der Stilllegungs- Anforderungssignalen sukzessive an jeweils eine Testpunktkarte (2),
- sukzessive Unterteilung der Testpunktkarten (2) in zwei gleich große oder unterschiedliche Hälften und Ausgabe des Stilllegungs-Anforderungssignals (S2) an eine angesprochene Hälfte,
Überprüfung, ob nach Abschaltung der angesprochenen Hälfte von Testpunktkarten (2) der Fehler und/oder Potentialstörungen weiterhin vorliegt,
falls der Fehler weiterhin vorliegt, weitere Unterteilung der nicht angesprochenen Hälfte von Testpunktkarten (2) durch Ausbildung neuer Hälften,
falls der Fehler und/oder die Potentialstörung nicht vorliegt, nachfolgende Stilllegung der zuvor nicht angesprochenen Hälfte und Unterteilung der zuvor angesprochenen, stillgelegten Hälfte in zwei Hälften.

18. Verfahren nach einem der Ansprüche 15 bis 17,
**dadurch gekennzeichnet, dass**
bei Erkennen einer Potentialstörung zunächst ein Störungssignal (S4) ausgegeben wird,
und bei Eingabe eines Initiierungs-Signals (S5) zur Fehlerdiagnose nachfolgend die Diagnoseroutine des Verfahrens nach einem der Ansprüche 15 bis 17 zum selbsttätigen Lokalisieren der fehlerhaften Testpunktkarte (2) gestartet wird.

19. Verfahren nach Anspruch 18, **dadurch gekennzeichnet, dass** bei Eingabe eines manuellen Auswahlsignals (S5) zur Auswahl einer oder mehrerer Testpunktkarten (2) von der zentralen Steuereinrichtung (4) nachfolgend ein Stilllegungs- Anforderungssignal (S2) an lediglich die eine oder mehrere ausgewählte Testpunktkarten (2) ausgegeben wird.

## Claims

1. Test point card device (5) for a test bench (1) for testing a wire harness (10) or a cable loom,
comprising a test point card (2), comprising:
- a plurality of test points (6),
- modules (8) for receiving one connector (9) each of the cable loom (10) or the wire harness, whereby in a module (8) always one or more test points (6) are housed or contacted,
- a current and voltage connector (2a) for connecting a power cable (11) with at least one supply voltage line (11a, 11b) and a ground line (11c) as power supply for the modules (8),
where a power supply interrupter device (16) is provided by means of which the at least one supply voltage line (11a, 11b) and the grounds line (11c) can be separated from the modules (8),
**characterized in that**
the test point card (2) comprises a test point control unit (3) for controlling the individual test points (6) and data communication with a central control unit (4) of the test bench (1),
said power supply interrupter device (16) is provided with a control input (17) for separating the lines (11a, 11b, 11c) upon receipt of an interrupt signal (S1),
a control line (18) is connected between a test point serving as control test point (6a) and said control input (17),
where each test point (6) can be contacted as control test point (6a) via the control line (18), and
- said test point control unit (3) is designed to put out, upon receipt of an external shut-down request signal (S2), an interrupt signal (S1) via said control test point (6a) and said control line (18) to said control input (17) of said power supply interrupter device (16).

2. Test point card device (5) according to claim 1, **characterized in that** said power supply interrupter device (16) is wired upstream from said current and voltage connector (2a).

3. Test point card device (5) according to claim 2, **characterized in that** said power supply interrupter device (16) is wired between two power cable segments (11a, 11b) of a power cable (11) with the supply voltage line (11a, 11b) and the grounds wire (11c), said second power cable segment (11e) being wired between said power supply interrupter device (16) and said current and voltage connector (2a).

4. Test point card device (5) according to claim 2 or 3, **characterized in that** said test point card (2) is provided with a circuit carrier, e.g. a circuit board (15), upon which said test point card control unit (3), a data bus connection, and said current and voltage connector (2a) are mounted,
said power supply interrupter device being housed outside said circuit carrier (15) on a separate circuit carrier (16).

5. Test point card device (5) according to one of the above claims, **characterized in that** said power supply interrupter device (16) is designed as a relay device, e.g. a relay circuit board for galvanically separating the lines (11a, 11b, 11c) to attain a complete interruption of potential.

6. Test point card device (5) according to one of the above claims, **characterized in that** the power supply of said test points (6) cannot be interrupted by said interrupter device (16) and said test point control unit (3) is continually supplied with power even in the event of an interruption of voltage of said adapters (8) by means of said interrupter device (16).

7. Test point card device (5) according to one of the above claims, **characterized in that** said interrupt signal (S1) is a current or voltage signal corresponding to the load on the modules (8) with current values or voltage values, preferably a voltage signal with constant voltage, e.g. grounds (0 V).

8. Test point card device (5) according to one of the above claims, **characterized in that** said test point card (2) further comprises an interface (13), in particular a bus interface (13), for a data bus (12), for communication of said test point card control unit (3) with said central control unit (4) of said test bench (1),
whereby said shut-down request signal (S2) from said central control unit (4) can be picked up via said interface (13), and this instructs said test point card control unit (3) to assign a potential or provide a current to said control test point (6a), and
said power supply of said interface (13) and said test point card control unit (3) cannot be interrupted by said power supply interrupter device (16), preferably by means of a power supply of said test point card control unit (3) via said interface (13).

9. Test point card device (5) according to one of the above claims, **characterized in that** said modules (8) are adapters (8) for receiving, preferably in a form-fit manner, of one connector (9) each of said wire harness (10).

10. Test point card device (5) according to one of the above claims, **characterized in that** said power supply interrupter device (16) further puts out an output signal (S10) to a further device.

11. Test bench (1) for testing a wire harness (10) or cable loom,
said test bench (1) comprising:
a central control unit (4), e.g. a PC,
several test point card devices (5) according to one of the above claims,
a data bus (12), via which said test point cards (2) are each connected to said central control unit (4),
said test point cards (2), when said control line (18) is connected to one of their test points (6), being adaptable to automatically separate the power supply of their modules (8),
said central control unit (4) being adapted to put out shut-down request signals (S1) to said individual test point cards (2) via said data bus (12),
whereby within or outside of said central control unit (4) a testing routine is stored, upon activation of which said shut-down request signals (S1) can be put out by said central control unit (4) successively to sequentially shut down said test point cards (2) while localizing a potential fault in one or more individual test point cards (2).

12. Test bench (1) according to claim 11, **characterized in that** said power cables (11) are connected to a central adapter power supply device (14a) for supplying said modules (8) of said individual test point card devices (5) with power and,
further, said test points (6) of said test point cards (6) are connected to a common test point power supply (14b),
e.g. in a star layout or in a chain.

13. Test bench (1) according to claim 11 or 12, **characterized in that** in an internal or external memory of said central control unit (4) a testing routine is stored, for successively shutting down said several test point card devices (5) by putting out shut-down request signals (S2) when a potential fault is detected and/or upon reception of an initiating signal (S5).

14. Test bench (1) according to one of the claims 11 through 13, **characterized in that** in an internal or external memory of said central control unit (4) it is stored which test point of said individual test point cards (2) respectively forms said control test point (6a), e.g. as a number or address of said control test point (6a).

15. Method for detecting a faulty test point card (2) of a test bench (1) according to one of the claims 11 through 14, comprising at least the following steps:
successively putting out shut-down request signals (S1) from said central control unit (4) to said test point control unit (3) of said individual test point cards (2),
upon receipt of a shut-down request signal (S1) by a test point card control unit (3), putting out a voltage signal as interrupt signal (S2) via a test point (6) and a control line (18) to a power supply interrupter device (16) for potential separation and/or galvanic separation of the wires (11a, 11b, 11c) for supplying said modules (8),
localizing by means of successively shutting off the individual test point cards (2) until at least one test point card (2) exhibiting the potential fault or the error has been detected.

16. Method according to claim 15, **characterized in that** it comprises at least the following steps:
checking whether an error, in particular, a potential fault, e.g. a short-circuit, is present (St1),
putting out shut-down request signals (S2) to a part of said test point card devices (2) (St2),
upon receipt of a shut-down request signal (S1) by a test point card control unit (3), putting out an interrupt signal (S1) to the upstream power supply interrupter device (16) for galvanically interrupting the voltage wire (11a, 11b) and a grounds wire (11c) to said modules (8) of said test point card (2),
successively repeating the steps of checking for error and/or potential fault and putting out shut-down request signals (S2) for localising or identifying the faulty test point card (2).

17. Method according to claim 15 or 16, **characterized in that** said several test point cards (2) are controlled by said shut-down request signals (S2) successively by means of one of the following procedures:
- block-wise controlling of several test point cards (2) for detecting a faulty block with subsequent detection of the faulty test point card (2) in that block,
- serial controlling by means of putting out said shut-down request signals successively to one test point card (2) each,
- successively subdividing said test point cards (2) into two halves of equal or unequal size and putting out said shut-down request signal (S2) to an addressed half,
checking whether upon shut-down of said addressed half of test point cards (2) the error and/or potential fault still remains,
in the event that the error remains, further subdividing the non-addressed half of test point cards (2) by creating new halves,
in the event that the error and/or the potential fault remains is no longer present, subsequently shutting down the previously non-addressed half and subdividing previously addressed, shut down half into two halves.

18. Method according to one of the claims 15 through 17, **characterized in that**
upon recognizing a potential fault firstly an error signal (S4) is put out, and upon entry of an initiation signal (S5) for error diagnosis, subsequently, the diagnosis routine for automatically localizing the faulty test point card (2) according to one of the claims 15 through 17 is started.

19. Method according to claim 18, **characterized in that** upon entry of a manual selection signal (S5) for selecting one or more test point cards (2) said central control unit (4) subsequently puts out a shut-down request signal (S2) to only said one or more selected test point cards (2).

## Revendications

1. Dispositif à carte à points de test (5) pour une table d'essai (1) servant à essayer un harnais de câbles ou un faisceau de câbles, le dispositif comportant une carte à points de test (2) qui présente :
- une pluralité de points de test (6),
- des modules (8) servant à recevoir respectivement une prise (9) du harnais de câbles (10) ou du faisceau de câbles, un ou plusieurs points de test étant reçus ou contactés,
- un branchement de courant et de tension (2a) pour le branchement d'un câble électrique (11) avec au moins une ligne de fourniture de tension d'alimentation (11a, 11b) et une ligne de masse (11c) pour l'alimentation en potentiel des modules (8),
- un dispositif d'interruption de l'alimentation en courant 16) étant prévu, au moyen duquel l'au moins une ligne de fourniture de tension d'alimentation (11a, 11b) et la ligne de masse (11c) peuvent être séparées,
**caractérisé en ce que**
- la carte à points de test (2) présente un dispositif de commande de carte à points de test (3) pour le pilotage des points de test individuels (6) et la communication de données avec une unité de commande centrale (4) de la table d'essai (1),
- le dispositif d'interruption de l'alimentation en courant (16) présentant une entrée de commande (17) pour la séparation des lignes (11a, 11b, 11c) en cas de réception d'un signal d'interruption (S1),
- une ligne de commande (18) étant connectée entre un point de test servant de point de test de commande (6a) et l'entrée de commande (17), chaque point de test (6) pouvant être contacté comme point de test de commande (6a) via la ligne de commande (18), et
- le dispositif de commande de points de test (3) étant conçu pour fournir, en cas de réception d'un signal de demande de mise hors service externe (S2), un signal d'interruption (S1) via le point de test de commande (6a) et la ligne de commande (18) à l'entrée de commande (17) du dispositif d'interruption de l'alimentation en courant.

2. Dispositif à carte à points de test (5) suivant la revendication 1, **caractérisé en ce que** le dispositif d'interruption de l'alimentation en courant (16) est connecté en amont du branchement de courant et de tension (2a).

3. Dispositif à carte à points de test (5) suivant la revendication 2, **caractérisé en ce que** le dispositif d'interruption de l'alimentation en courant (16) est connecté entre deux tronçons de câble (11d, 11e) d'un câble électrique (11), avec la ligne de fourniture de tension d'alimentation (11a, 11b) et la ligne de masse (11c), le second tronçon de câble électrique (11e) étant connecté entre le dispositif d'interruption de l'alimentation en courant (16) et le branchement de courant et de tension (2a).

4. Dispositif à carte à points de test (5) suivant la revendication 2 ou 3, **caractérisé en ce que** la carte à points de test (2) présente un support de circuit, par exemple une platine (15), sur lequel sont montés le dispositif de commande de carte à points de test (3), une connexion de bus de données, le branchement de courant et d'alimentation (2a), le dispositif d'interruption de l'alimentation en courant étant reçu à l'extérieur du support de circuit (15), sur un support de circuit séparé (16).

5. Dispositif à carte à points de test (5) suivant une des revendications précédentes, **caractérisé en ce que** le dispositif d'interruption de courant de l'alimentation en courant (16) est conçu comme dispositif relais, par exemple comme platine à relais servant à la séparation galvanique des lignes (11a, 11b, 11c) pour une interruption de potentiel intégrale.

6. Dispositif à carte à points de test (5) suivant une des revendications précédentes, **caractérisé en ce que** l'alimentation en courant des points de test (6) ne peut pas être interrompue par le dispositif d'interruption de l'alimentation en courant (16) et le dispositif de commande de carte à points de test (3) est toujours alimenté en tension, même à alimentation en tension des modules (8) interrompue par le dispositif d'interruption de l'alimentation en courant (16).

7. Dispositif à carte à points de test (5) suivant une des revendications précédentes, **caractérisé en ce que** le signal d'interruption (S1) est un signal de courant ou de tension selon l'application de valeurs de courant ou de tension (13) aux modules (8), de préférence, un signal de tension avec une tension constante, par exemple avec une masse (0V).

8. Dispositif à carte à points de test (5) suivant une des revendications précédentes, **caractérisé en ce que** la carte à points de test (2) présente en plus une interface (13) en particulier une interface de bus (13) pour un bus de données (12) pour la communication du dispositif de commande de carte à points de test (3) avec l'unité de commande centrale (4) de la table d'essai (1), le signal de demande de mise hors service (S2) de l'unité de commande centrale (4), qui donne l'instruction au dispositif de commande de carte à points de test (3) d'appliquer un potentiel au point de test de commande (6a) ou de l'alimenter en courant, pouvant être reçu via l'interface (13), et l'alimentation en courant de l'interface (13) et du dispositif de commande de carte à points de test (3) ne pouvant pas être interrompue par le dispositif d'interruption de l'alimentation en courant (16), de préférence avec une alimentation en courant du dispositif de commande de carte à points de test (3) via l'interface (13).

9. Dispositif à carte à points de test (5) suivant une des revendications précédentes, **caractérisé en ce que** les modules (8) sont des adaptateurs (8) servant de préférence à la réception par complémentarité de formes d'une prise (9) respectivement du harnais de câbles (10).

10. Dispositif à carte à points de test (5) suivant une des revendications précédentes, **caractérisé en ce que** le dispositif d'interruption de l'alimentation en courant (16) fournit en plus un signal d'émission (S10) à un autre dispositif.

11. Table d'essai (1) servant à essayer un harnais de câbles (10) ou un faisceau de câbles, la table d'essai (1) présentant :
- une unité de commande centrale (4) par exemple un PC,
- plusieurs dispositifs à cartes à points de test (5) suivant une des revendications précédentes,
- un bus de données (12), via lequel les cartes à points de test (2) sont reliées à l'unité de commande centrale (4), les cartes à points de test (2) pouvant être conçues de manière à effectuer automatiquement une interruption de l'alimentation en courant de ses modules (8) en cas de connexion de la ligne de commande (18) à un de ses points de test (6), l'unité de commande centrale (4) étant conçue pour fournir des signaux de demande de mise hors service (S1) aux différentes cartes à points de test (2) via le bus de données (12), une routine d'essai étant mémorisée à l'intérieur ou à l'extérieur de l'unité de commande centrale (4), lors de l'activation de laquelle par l'unité de commande centrale (4), les signaux de demande de mise hors service (S1) pouvant être émis successivement pour une mise hors service successive des cartes à points de test (2) tout en localisant une défaillance de potentiel sur une ou plusieurs cartes à points de test individuels (2).

12. Table d'essai (1) suivant la revendication 11, **caractérisé en ce que** les câbles électriques (11) servant à l'alimentation en potentiel des modules (8) des différents dispositifs à carte à points de test (5) sont connectés à une unité centrale d'alimentation en courant des adaptateurs (14a), et, en plus, les points de test (6) des cartes à points de test (2) sont connectés à une alimentation en potentiel commune des points de test (14b), par exemple sous forme d'une configuration en étoile ou en chaîne.

13. Table d'essai (1) suivant la revendication 11 ou 12, **caractérisé en ce qu'une** routine d'essai est mémorisée dans une mémoire interne ou externe de l'unité de commande centrale (4) pour la mise hors service successive des plusieurs dispositifs à carte à points de test (5) en émettant des signaux de demande de mise hors service (S2) en cas de reconnaissance d'une défaillance de potentiel et/ou en cas de réception d'un signal d'initiation (S5).

14. Table d'essai (1) suivant la revendication 11 à 13, **caractérisé en ce que** dans une mémoire interne ou externe de l'unité de commande centrale (4) il est mémorisé quel point de test des différentes cartes à points de test (2) forme respectivement le point de test de commande (6a), par exemple sous la forme d'un numéro ou d'une adresse du point de test de commande (6a).

15. Procédé de reconnaissance d'une carte à points de test (2) défaillante d'une table d'essai (1) suivant une des revendications 11 à 14, le procédé comportant au moins les étapes suivantes :
- fourniture successive de signaux de demande de mise hors service (S1) par l'unité de commande centrale (4) au dispositif de commande de points de test (3) des différentes cartes à points de test (2),
- en cas de réception d'un signal de demande de mise hors service (S1) par un dispositif de commande de cartes à points de test (3), fourniture d'un signal de tension comme signal d'interruption (S2) via un point de test (6) et une ligne de commande (18) à un dispositif d'interruption de l'alimentation en courant (16) pour la séparation de potentiel et/ou la séparation galvanique des lignes (11a, 11b, 11c) pour l'alimentation des modules (8),
- localisation par mise hors service successive des différentes cartes à points de test (2) jusqu'à ce que l'au moins une carte à points de test (2) avec la défaillance de potentiel ou l'erreur soit reconnue.

16. Procédé suivant la revendication 15, **caractérisé en ce qu'**il présente au moins les étapes suivantes :
- vérification s'il y a une erreur, en particulier une défaillance de potentiel, par exemple un court-circuit (St1),
- fourniture d'un signal de demande de mise hors service (S2) à une partie des cartes à points de test (2) (St2),
- en cas de réception d'un signal de demande de mise hors service (S2) par un dispositif de commande de carte à points de test (3) d'une carte à points de test (2), fourniture d'un signal d'interruption (S1) au dispositif d'interruption de l'alimentation en courant (16) connecté en amont pour l'interruption galvanique des lignes de tension (11a, 11b) et d'une ligne de masse (11c) aux modules (8) de la carte à points de test (2),
- répétition successive des étapes de vérification d'erreur et/ou de défaillance de potentiel et sortie de signaux de demande de mise hors service (S2) pour localiser ou identifier la carte à points de test défaillante (2).

17. Procédé suivant la revendication 15 ou 16, **caractérisé en ce que** les plusieurs cartes à points de test (2) sont pilotées successivement par les signaux de demande de mise hors service selon un des procédés suivants :
- pilotage par blocs de plusieurs cartes à points de test () pour reconnaître un bloc défectueux suivi d'une reconnaissance de la carte à points de test défectueuse (2) dans le bloc,
- pilotage sériel par fourniture de signaux de demande de mise hors service successivement à une carte à points de test (2) respectivement.
- division successive des cartes de points de test (2) en deux moitiés de grandeur identique ou différente et fourniture du signal de demande de mise hors service (S2) à une moitié adressée,
- vérification si l'erreur et/ou les défaillances de potentiel persistent après la mise hors service de la moitié de cartes à points de test (2) adressée,
- en cas de persistance de l'erreur et/ou de la défaillance de potentiel, procéder à une autre division de la moitié non adressée des cartes à points de test (2) en formant de nouvelles moitiés,
- en cas d'absence de l'erreur et/ou de la défaillance de potentiel, mise hors service de la moitié précédemment non adressée et division de la moitié précédemment adressée et mise hors service en deux moitiés.

18. Procédé suivant une des revendications 15 à 17, **caractérisé en ce qu'**en cas de reconnaissance d'une défaillance de potentiel, c'est d'abord un signal de défaillance (S4) qui est émis, et lors de l'entrée d'un signal d'initiation (S5) pour un diagnostic d'erreur, la routine de diagnostic du procédé suivant une des revendications 15 à 17 pour la localisation automatique de la carte à points de test défaillante est lancée.

19. Procédé suivant la revendication 18, **caractérisé en ce qu'**en cas d'entrée d'un signal de sélection manuelle (S5) pour la sélection d'une ou de plusieurs cartes à points de test (2) par l'unité de commande centrale (4), un signal de demande de mise hors service (S2) est fourni uniquement à une ou plusieurs cartes à points de test (2) sélectionnées.
